# EUROPEAN PATENT APPLICATION

(11) **EP 2 688 092 A1**
(43) Date of publication of application: **22.01.2014**
(21) Application number: 12305874.5
(22) Date of filing: 19.07.2012
(51) Int. Cl.: H01L 21/768, H01L 23/48

(54) **Semiconductor die with a through silicon via and corresponding manufacturing process**

(71) Applicant: IPDIA, 14000 Caen (FR)
(72) Inventor: Tenailleau, Jean-René, 14250 Hottot-Les-Bagues (FR); Voiron, Frédéric, 38530 Barraux (FR)
(74) Representative: Cabinet Plasseraud

(57) **Abstract**

A semiconductor die according to this invention comprises a via realised in a bulk material (2).

The via has an inner metallic conductor (28) isolated by a dielectric layer (17, 20) from a surrounding conductive area (16).

The bulk material (2) is chosen in a set of doped semiconductor materials containing n-type and p-type materials. The surrounding conductive area (16) is in contact with the bulk material (2) and the surrounding conductive area (16) is made from a material chosen in a set of doped semiconductor materials containing n-type and p-type materials, the surrounding conductive area material being from one type among the n-type and the p-type, and the bulk material being from the other type among said n-type and said p-type.

## Description

The present invention concerns a semiconductor die with a through silicon via and a manufacturing process of such a die.

The invention generally relates to integrated circuits (ICs) and more specifically to three-dimensional (3D) integration techniques in which multiple layers of ICs are stacked.

3D integration of circuits or packages is a known concept which can significantly reduce the size of an electronic system and also its cost. It allows therefore increasing density of integration of functions in ICs.

ICs may have integrated components arranged on one side of a silicon die. For systems having a three dimensional architecture, it is usual to have a layer, or interposer, comprising at least a via arranged to interconnect two ICs and contacts may be provided on both sides of interposer. Such vias permit the routing of signals between the various layers of the structure.

In a multilayer structure in which dies are stacked and in which one of them is e.g. an interposer, different functions required by the stacked system (like for example memory or processor) can be, at least partially, embedded onto the interposer. With this integration scheme, there can be differentiated:
- a first kind of interposer made from an active or passive integrated circuit, in which all the components are embedded on one side (only) of the interposer that is then assembled on a board by a so called "Double Flip Chip" process, and
- a second kind of interposer made from an active or passive integrated circuit, in which the components are embedded on two opposite sides of the interposer and are electrically intra-connected by means of "Through Silicon Vias" (or TSVs). Such interposers use a semiconductor substrate as bulk material for the implementation of the TSV(s).

The invention concerns more specifically but not exclusively this second kind of interposers.

When a via is implemented in a silicon substrate, it is desirable to electrically isolate it from the substrate. The insulation of the via concerns DC (direct current) insulation and also AC (alternative current) insulation.

The DC insulation of a via may be realised by coating the inner wall of the via with a dielectric layer. After this first insulation, the via is then coated with a stack of metallic layers comprising at least a barrier layer and a conductive layer. The barrier layer is for example a ruthenium or a tungsten nitride or a titanium nitride layer or a titanium (or another metallic material) layer or a combination of above. The conductive layer can be realised by a process such for example PVD (Physical Vapor Deposition) or MOCVD (Metal Organic Chemical Vapour Deposition) or ECD (Electrochemical Deposition) or electro-greffage. A conductive layer realised by an ECD process can also comprise the combination of a seed layer made of ruthenium or titanium coated with a copper deposited by PVD or MOCVD and with a thick copper layer grown by ECD.

The AC insulation permits the reduction of the coupling between the via and the surrounding material, namely the silicon, when for example a radio frequency (RF) signal is transmitted through the via. This coupling is mostly capacitive for signals conducted through the via and propagates through the parasitic capacitor formed by the inner-conductive layer forming a first electrode of this parasitic capacitor and the bulk silicon forming the second electrode of this capacitor. This coupling is responsible for energy losses. If there are more than one via, the coupling may also results in a crosstalk between adjacent vias.

US-7,989,915 discloses a vertical electrical device that includes a region in a substrate extending from a surface of the substrate, the region having an inner wall and an outer wall circumscribing the inner wall. An inner electrically conductive layer is disposed on the inner wall and an outer electrically conductive layer is disposed on the outer wall, with an electrically insulative material disposed between the inner and outer layers. An electrical conductor in the substrate is bounded by the inner electrically conductive layer.

WO-2010/144467 shows a semiconductor die, having a substrate and including a through silicon via. The through silicon via includes a decoupling capacitor having a first co-axial conductor, a second co-axial conductor and a co-axial dielectric separating the first co-axial conductor from the second co-axial conductor. The decoupling capacitor is configured to provide local charge storage for components on the semiconductor die.

WO-2011/056374 discloses a through-silicon via (TSV) structure forming a unique co-axial or tri-axial interconnect within a silicon substrate. The TSV structure is provided with two or more independent electrical conductors insulated from another and from the substrate. The electrical conductors can be connected to different voltages or ground, making it possible to operate the TSV structure as a co-axial or tri-axial device. Multiple layers using various insulator materials can be used as insulator, wherein the layers are selected based on dielectric properties, fill properties, interfacial adhesion, CTE match, and the like. The TSV structure overcomes defects in the outer insulation layer that may lead to leakage. A method of fabricating such a TSV structure is also described in this document.

It is an object of the invention to provide a structure of a via which ensures a good insulation between itself and the surrounding bulk material. The invention concerns both, direct current insulation and alternative current insulation.

It is another object of the invention to provide a new via which allows having co-axial or tri-axial via structure with an outer grounded shielding conductive layer. Preferably, the characteristic impedance of a such via will be able to be adjusted in view of limiting reflexion at the ends of the via.

To this end, the invention proposes a semiconductor die comprising a via realised in a bulk material, the via having an inner metallic conductor isolated from a surrounding conductive area by a dielectric layer.

According to the invention, the bulk material is chosen in a set of doped semiconductor materials containing n-type and p-type materials; the surrounding conductive area is in contact with the bulk material, and the surrounding conductive area is made from a material chosen in a set of doped semiconductor materials containing n-type and p-type materials, the surrounding conductive area material being from one type among the n-type and the p-type, and the bulk material being from the other type among said n-type and said p-type, thus forming a tubular PN junction to the substrate.

In this new and original structure, the achieved via is surrounded by a conductive area obtained by diffusion of an opposite type dopant specie compared to the substrate, thus forming a PN junction with the substrate, this junction realising a very good shielding of the via.

The bulk material used in a die according to the invention is for example doped silicon.

The surrounding conductive area is preferably doped with phosphorus. In this case, the conductive area is then a n-doped area and the substrate is therefore preferably a p-doped material.

The inner metallic conductor is for example in copper and its thickness is preferably at least 0.5 µm.

In a semiconductor die according to the invention, the dielectric layer can be made in a material chosen in the set of materials comprising silicon oxide, silicon nitride, low permittivity Silicon Oxycarbide and low permittivity polymers.

A via of a semiconductor die according the invention can have a co-axial or tri-axial structure with an outer grounded shielding conductive layer. The characteristic impedance of a such via can be adjusted by DC biasing the diode with a proper biasing structure (like a DC bias feeded through a large inductance), such that the diode reverse capacitance is adjusted to the value ensuring best matching. The capacitance can also be minimized to prevent substrate coupling and thus power loss to the ground. In other word, the through silicon via can be used here as a tunable low pass filter. This is particularly useful in applications like medical implantable appliance where low frequency biological signals are to be measured while all HF/RF (i.e. high frequency or radio frequency) signals are to be rejected to ground (for example 64 MHz MRI signals -i.e. Magnetic Resonance Imaging signals-).

The invention provides a new via which uses a tubular diode cathode (N type doping) to propagate a signal, for example an RF signal, and the anode (P type doping) is left floating. In this particular configuration, when another cathode -belonging to a neighbouring via- is connected to the ground (GND), one obtained a back-to-back tubular diode structure that is natively self-protecting the signal vias against electrostatic discharge. The ratio signal/GND vias can be adjusted to optimize the performance of the electrostatic discharge (ESD) protection structure, i.e. reduction of resistance to the ground. This is particularly useful when the via is used for connecting ESD sensitive appliances.

In a semiconductor die according to the invention, the realized tubular diode has an advantageous junction surface compared to its footprint. Therefore the tubular diode allows local extraction of higher energy density compared to conventional surface diode components having similar footprint.

A semiconductor die according to the invention comprises also advantageously at least one trench capacity. The corresponding trenches and capacities can be realised at the same time than the via.

The invention also concerns a manufacturing process for manufacturing a semiconductor die as described here above. A manufacturing process according to the invention is **characterised in that** it comprises the steps of:
- providing a doped silicon substrate,
- etching a hole in the silicon substrate from a first side of the substrate, the hole having at least a circumferential lateral wall,
- doping the surface of the circumferential lateral wall and forming a doped layer so that the doping specie of the doped layer is the opposite type of the doping specie of the substrate,
- coating the doped layer with a dielectric layer,
- coating the inner wall of the hole with a metallic layer.

In a first embodiment of the process, the etched hole has a bottom and a further step of the process includes a grinding operation in which the substrate is grinded from a side opposite to the first side of the substrate until the bottom so that the hole in the substrate becomes a through silicon via.

The silicon substrate is a for example p-doped material. In this case, the surface of the circumferential lateral wall can be doped with phosphorous and the doping process can comprise the steps of:
- deposition of a phosphorous glass on the inner circumferential lateral surface of the hole by a low pressure chemical vapour deposition process,
- etching of the glass by using diluted hydro-fluoridric acid, and
- thermal treatment in an oven so that the dopant is driven into the substrate and activated.

The dielectric layer is for example made of a material chosen in the set of materials containing silicon oxide, silicon nitride, silicon oxycarbide and polymers.

A manufacturing process according to the invention advantageously also comprises a step of providing a barrier layer between the metallic layer and the dielectric layer to avoid the diffusion of the metal into the dielectric layer.

An advantageous embodiment of a process according to the invention foresees that during the etching of the hole, in a same step, trenches are etched. In this way, the trenches are realised in only one step with the hole and thereafter the corresponding capacities (or any other 3D passive component like for example isolation trenches, 3D diodes ...) can also be manufactured during the steps used for the realisation of the through silicon via. The hole and the trenches are preferably realised by Reactive lon Etching (RIE). With a such process, it is possible to realise holes and trenches with a high aspect ratio (i.e. ratio between the depth of the hole or the trench and its diameter or width.

The invention will now be described in more details by way of an example with reference to the accompanying drawings, in which:
Figures 1 to 24 show each a step from a process to realise a semiconductor die according the present invention, and
Figure 25 shows an embodiment of a semiconductor die according to the present invention.

Skilled persons in the art appreciate that elements in the figures are illustrated for simplicity and clarity and have not necessarily been drawn up to scale. For example, the dimensions of some of the elements in the figures may be exaggerated relative to other elements to help improve the understanding of the embodiments of the present invention. The numeral indications are only given as an example and are not limitative.

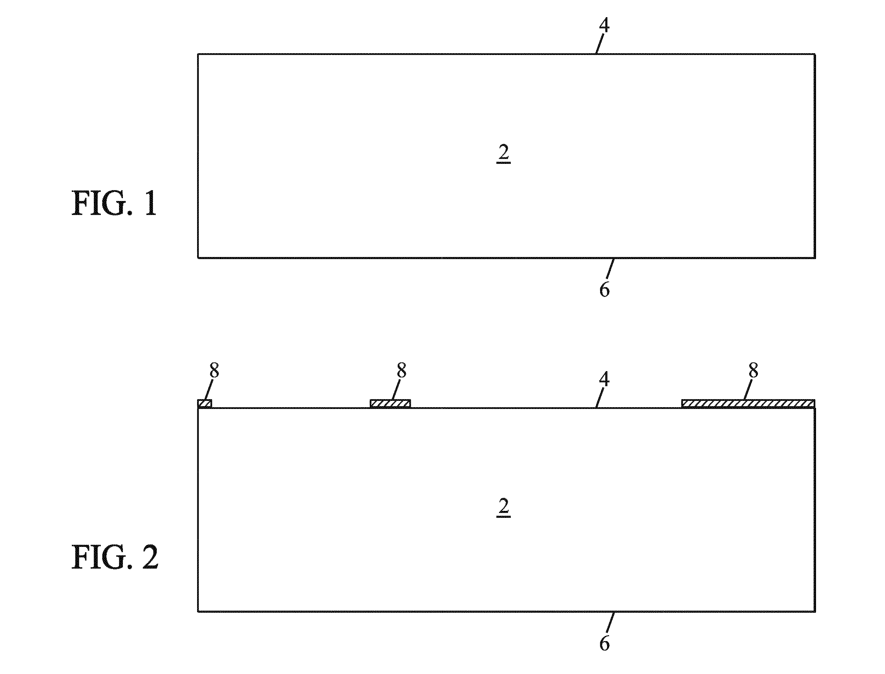

Figure 1 show a blank doped silicon substrate 2. This substrate 2 comes from a wafer of doped silicon, for example p-type silicon. It has a first side and a second side. In the following description, it will be considered that the substrate is oriented horizontally and that the first side is the upper side 4 of the substrate 2, the second side of the substrate 2 being the lower side 6.

In the step illustrated by figure 2, a nitride layer 8 is deposited, for example by a PECVD process and then patterned by combination of a lithography followed by an etch process step. This nitride layer 8 recovers partially the upper side 4 of the substrate 2. It is a protective layer for a further step of the process.

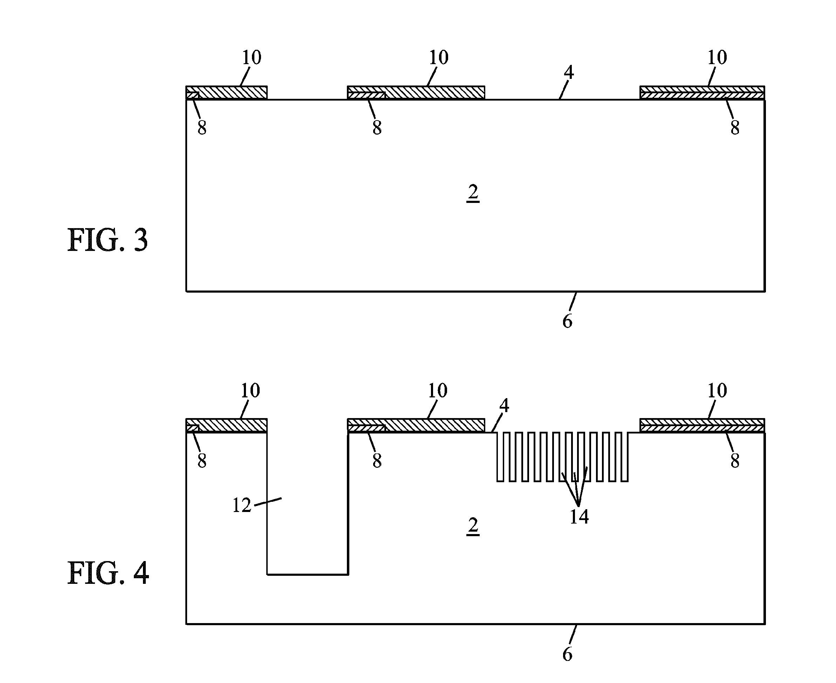

In the step corresponding to figure 3, a hard mask oxide layer 10 is deposited on the upper side 4 of the substrate 2 and recovers the entire nitride layer 8 and also an area around the nitride layer 8. This oxide layer 10 is preferably deposited by a PECVD process and then patterned by combination of a lithography followed by an etch process step.

The next step (figure 4) is a deep silicon etching step. The etching process is made from the upper face. On the link side of figure 4, a deep hole 12 is etched. The etch step is for example a dry etch step, such as RIE (Reactive lon Etching) or BOSH process, which is a RIE process with passivation and depassivation steps. The RIE process is used to obtain an anisotropic etch and allows therefore obtaining a high aspect ration (i.e. the ration between the depth of the hole and the diameter of the hole). The depth of the hole 12 is a little less than the thickness (i.e. the distance between the upper face 4 and the lower face 6) of the substrate.

In the same step (see the right side of figure 4) deep trenches 14 can also be etched. The trenches 14 have also a high aspect ratio but are less deep than the hole 12 because their width is less than the diameter of the hole 12.

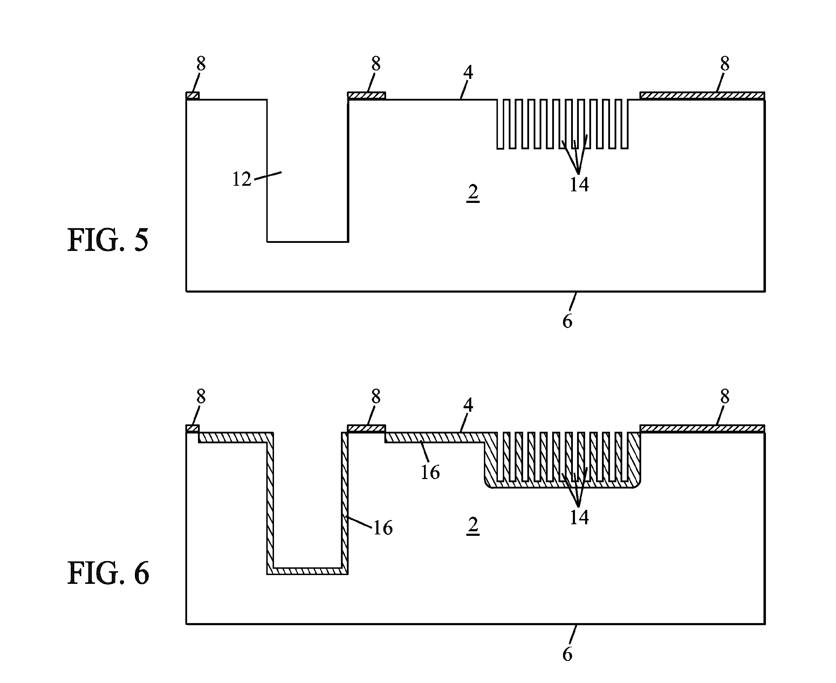

Once the etch step is achieved, the hard mask oxide 10 can be removed (figure 5) but the nitride layer 8 is kept. This layer is used as a mask for a further deposition step. From the upper side of the substrate 2, a conductive layer is deposited on the free surfaces (figure 6), i.e. the area of the upper side 4 which is not recovered by the nitride layer 8, the lateral surface and the bottom of the hole 12 and the trenches 14. In a preferred embodiment of a process according the invention, the conductive layer is an n-doped layer and more preferably a phosphorous doped layer 16. This step can be for example achieved by a chemical vapour deposition process followed by a thermal drive-in to ensure proper dopant species diffusion.

The phosphorous doped layer can also, in a preferred embodiment of the invention, be deposited by a LPCVD process (Low-Pressure Chemical Vapour Deposition).

This phosphorous doped layer 16 is deposed directly on the substrate 2. Since this layer is n-doped and the substrate is p-doped, a diode is realised, namely around the hole 12 at the junction between the n-doped and the p-doped areas.

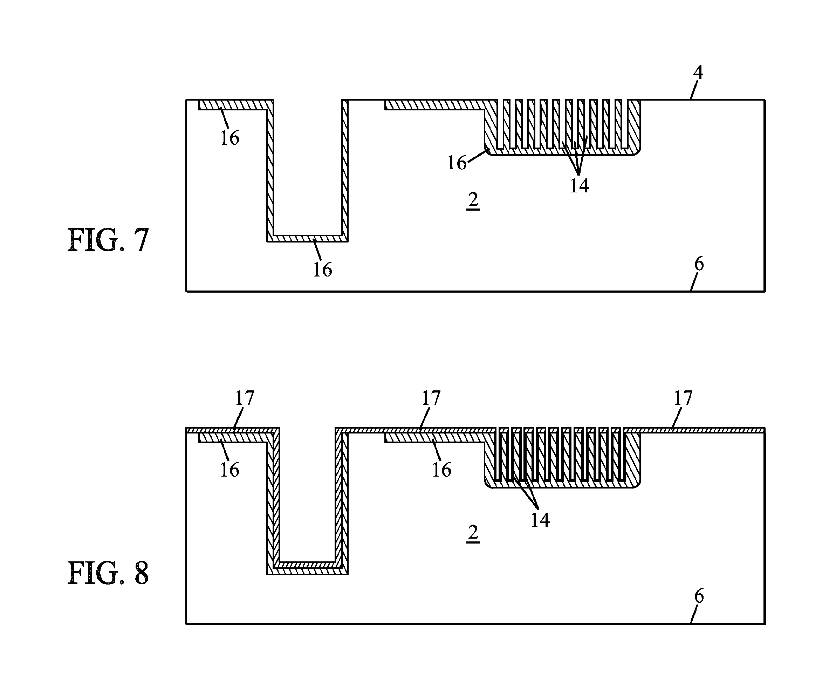

The next step (figure 7) proposed by the invention in the present process is the removal of the nitride layer 8. The upper side of the die corresponds again to the originally upper side 4 of the substrate 2.

Figure 8 illustrates a deposition of a dielectric layer 17 which recovers all the die, i.e. the upper side 4 of the substrate 2, the walls of the hole 12 (lateral wall and bottom) and also the walls of the trenches 14.

This dielectric layer 17 is for example an Oxide Nitride Oxide (ONO) or silicon oxide (SiO₂). It recovers the conductive layer (phosphorous doped layer 16) in the hole 12 and in the trenches 14.

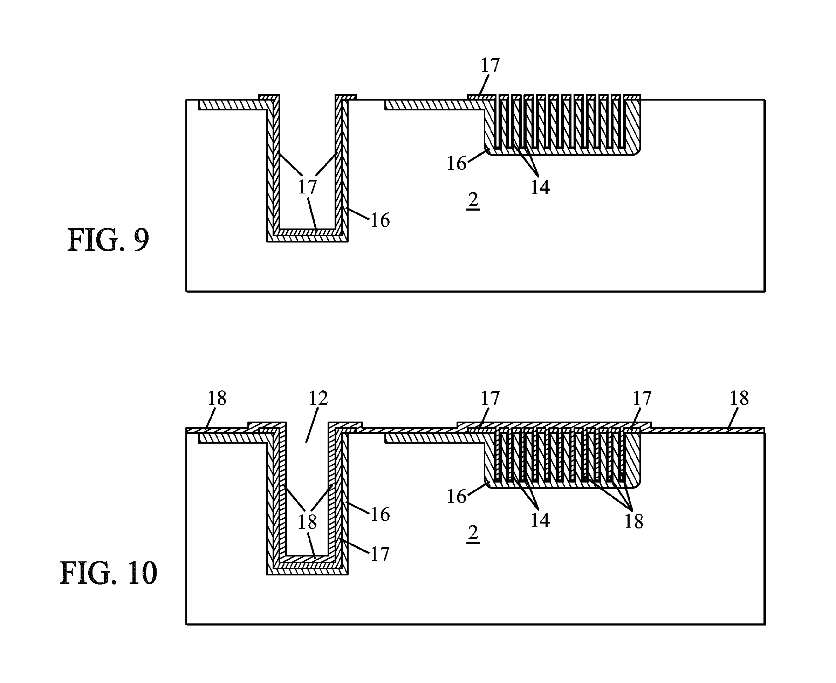

By way of lithography with a film resist, a part of the dielectric layer corresponding to the hole 12 and to the trenches 14 is protected and the rest of this dielectric layer 17 is removed by etching. In this way, the phosphorous doped layer 16 (conductive) is recovered with the dielectric layer 17 in the hole 12 and in the trenches 14 (figure 9).

The next step (figure 10) proposed in the embodiment of the invention illustrated by the drawings is a deposition of a polysilicon layer 18 which recovers all the die. This polysilicon layer recovers also the still free upper side of the substrate 2, the lateral walls and the bottom of the hole 12, and also the dielectric layer 17 inclusive over the walls of the trenches 14.

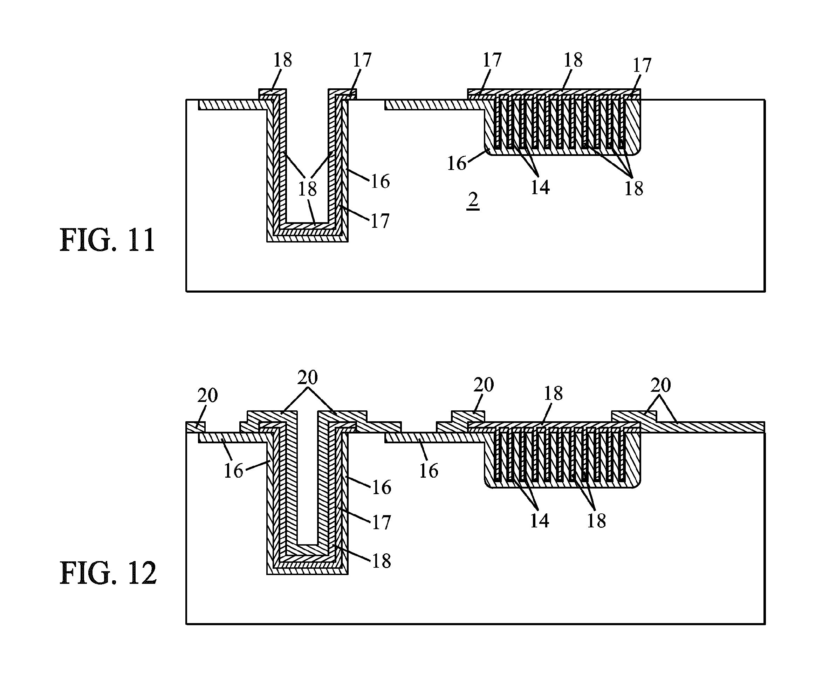

By way of lithography with a film resist, a part of the polysilicon layer 18 corresponding to the hole 12 and to the trenches 14 is protected and the rest of the polysilicon layer 18 is removed by etching (figure 11). In this way, the phosphorus doped layer 16 (conductive) is recovered with the dielectric layer 17 and together with the polysilicon layer 18 in the area from the hole 12 and from the trenches 14.

The next step is a deposition, lithography (with film resist) and etching step. As a result of this step (figure 12), an oxide layer 20 allows to do the contact in the area of the trenches 14 and makes an insulation in the area of the hole 12. The deposition of the oxide (silicon oxide) can be made by LPCVD or by thermal oxidation. These processes give a good uniformity for the oxide layer 20. After deposition, a part of the oxide layer is protected by a film and the remaining part of the layer is etched.

The thickness of the dielectric layer can for example be comprised between 40 nm and 1 µm. It depends from the used deposition technique. This dielectric layer comprises the oxide layer 20 and the optional dielectric layer 17. This last layer can be omitted for example if no trenches are realized nearby the vias.

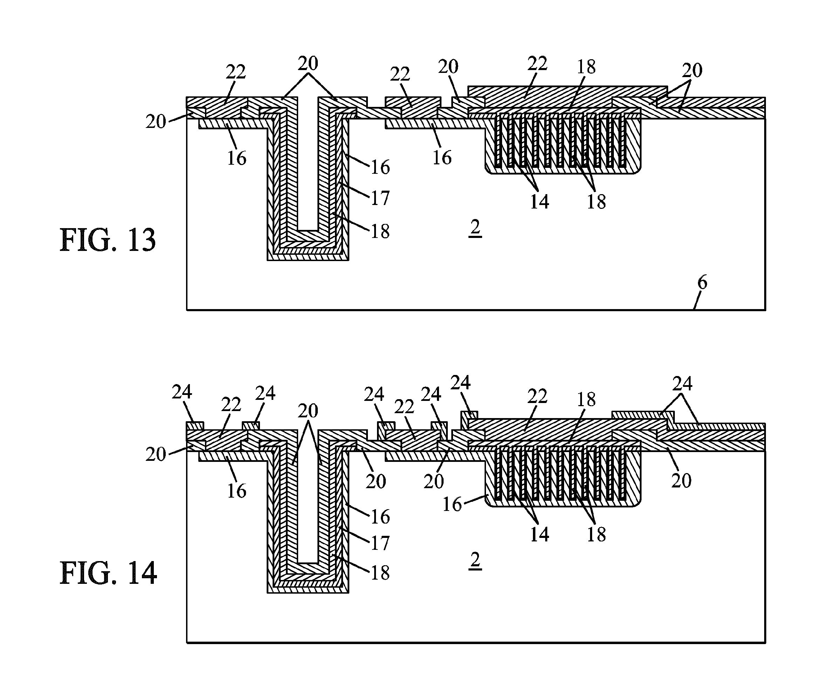

In the same way, the die is partially recovered with an aluminium -or any other metal- layer 22 (figure 13) and thereafter with a second oxide layer 24 (figure 14). The deposition of the second oxide is for example made by PECVD (Plasma Enhanced Chemical Vapour Deposition). The second oxide layer 24 extends the first oxide layer 20 and has the same function than this first oxide layer 20

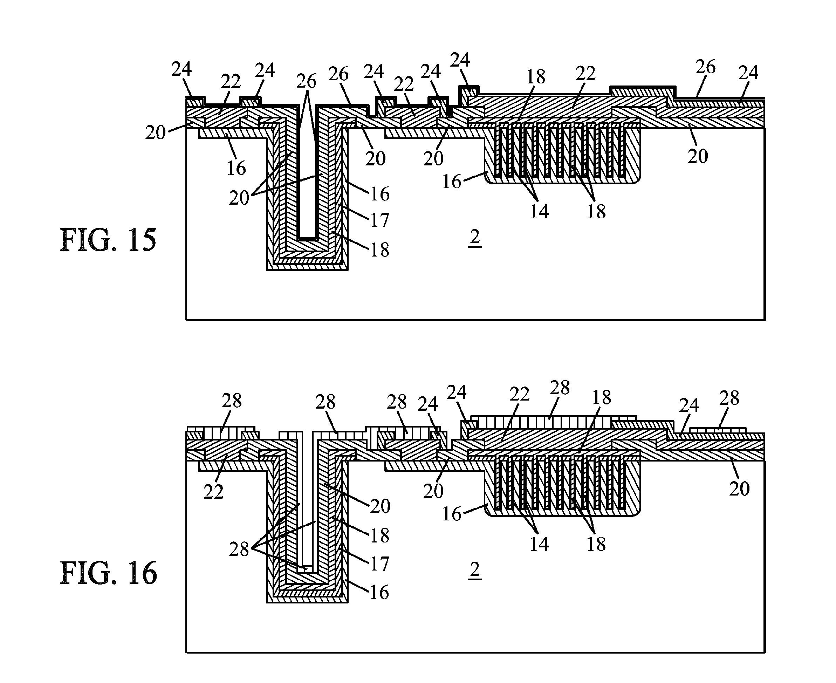

Figure 15 illustrates the installation of a barrier and seed layer 26. High temperature techniques, such as for example MOCVD or PVD or CVD (Chemical Vapour Deposition) or ALD (Atomic Layer Deposition), can be used for the deposition of the barrier. The seed layer can be set up by PVD for example. Titanium (Ti), titanium nitride (TiN), tantalum (Ta), tantalum nitride (TaN), ruthenium (Ru) or other materials can be used here.

The next step (figure 16) comprises a first 3D lithography phase using for example a negative resist or a resist film. So by the following phase of copper electroplating, targeted deposition of copper is realised. Copper 28 at least recovers the wall (lateral wall and bottom) of the hole 12 and also forms contacts for the structure realised in the hole and in the trenches 14. The copper layer is preferably a thick layer having a thickness of at least 3 µm. In an alternative embodiment, this layer (copper 28) can completely fill the hole 12.

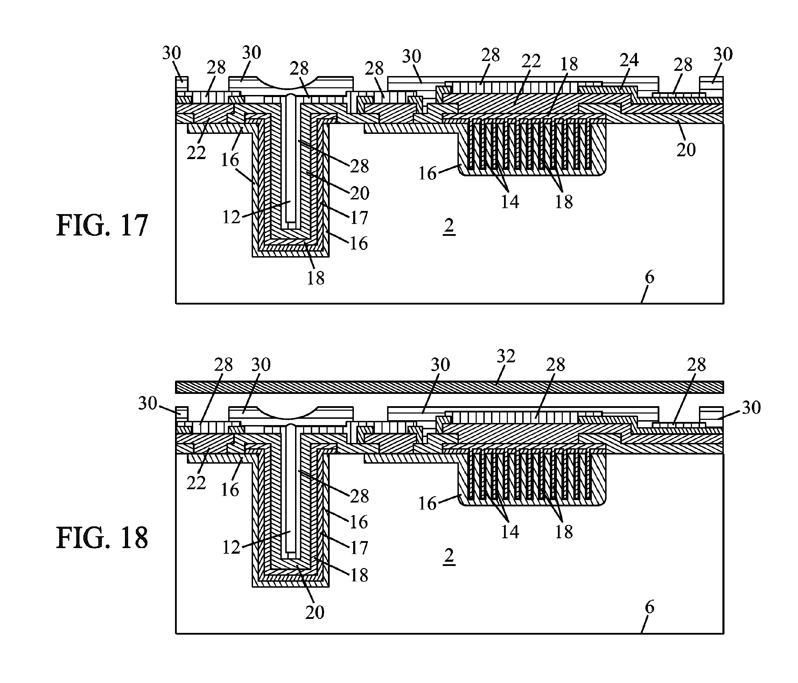

In the next step (figure 17), the invention propose a passivation coating for operculation, for example an organic passivation. This step can also eventually provide a complete hole filling. This step uses also lithography and realises a surface passivation 30 in particular over the hole 12 and the trenches 14.

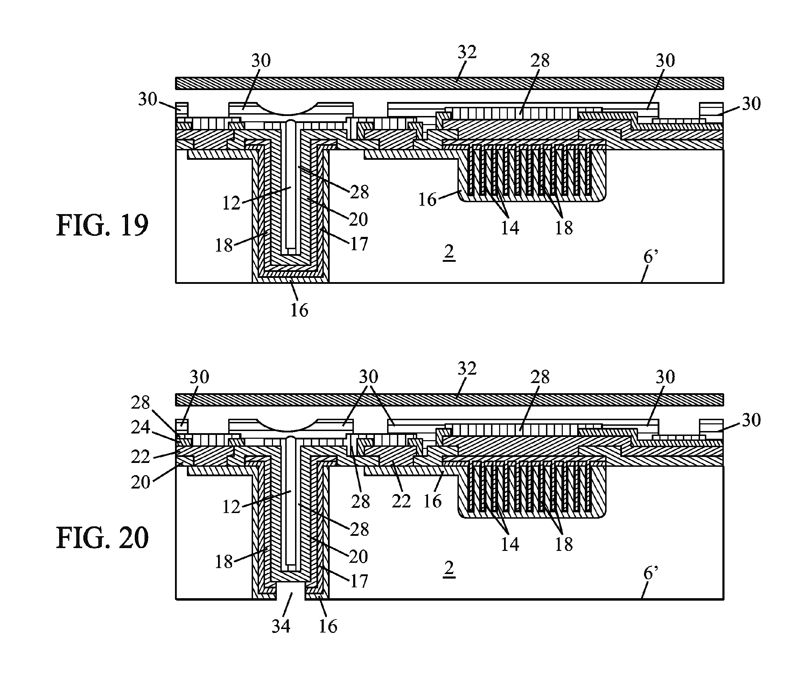

Following step (figure 18) is a preparation step in which the die is bonded on a glass substrate 32. So the die can be held for a thinning step (figure 19), for example by grinding, on the lower side 6 of the substrate 2. This last is thinned (grinded) in view of transforming the hole in a through silicon via (TSV). The thickness of the substrate 2 is reduced during this step so that the phosphorous doped layer 16 appears and a new lower side 6', which is flush with the phosphorous doped layer 16, is formed on the die.

Thereafter, an etching step is driven from the lower side of the die in the direction of the hole 12. Eventually silicon but essentially the phosphorous doped layer 16 and the dielectric layer 17 are etched and a cavity 34 is formed. The cavity 34 is preferably co-axial with the hole 12. At the bottom of the cavity 34, the oxide layer 20 appears. This layer is used as stopping layer for the etching of the cavity 34.

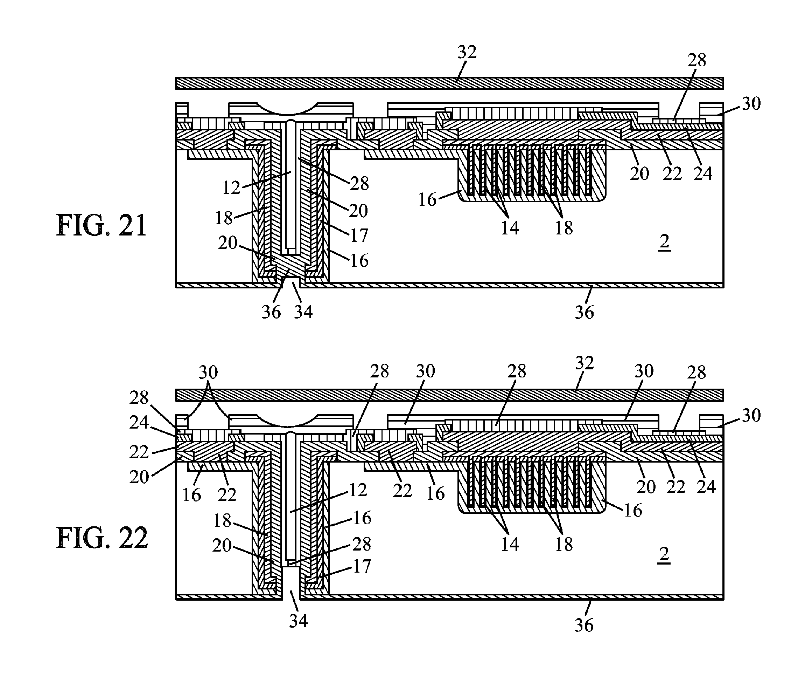

The lower side of the die is then recovered, totally or at least above the cavity 34 and around it, by a new oxide layer 36 of the same kind than the oxide layer 20. In this embodiment, the oxide layer 36 is then for example a silicon oxide layer. In the process illustrated on the figures and namely on figure 21, the entire lower side of the die is recovered with the silicon oxide layer. 36.

In order to realise a through silicon via, the copper 28 has to be accessible also from the lower side of the die. To this end, the oxide layer 36 and the oxide layer 20 are locally removed between the cavity 34 and the copper 28 in the hole 12 (figure 22). This can be done for example by contact etching, the barrier layer (copper 28) being used as a contact etch stop layer (CESL).

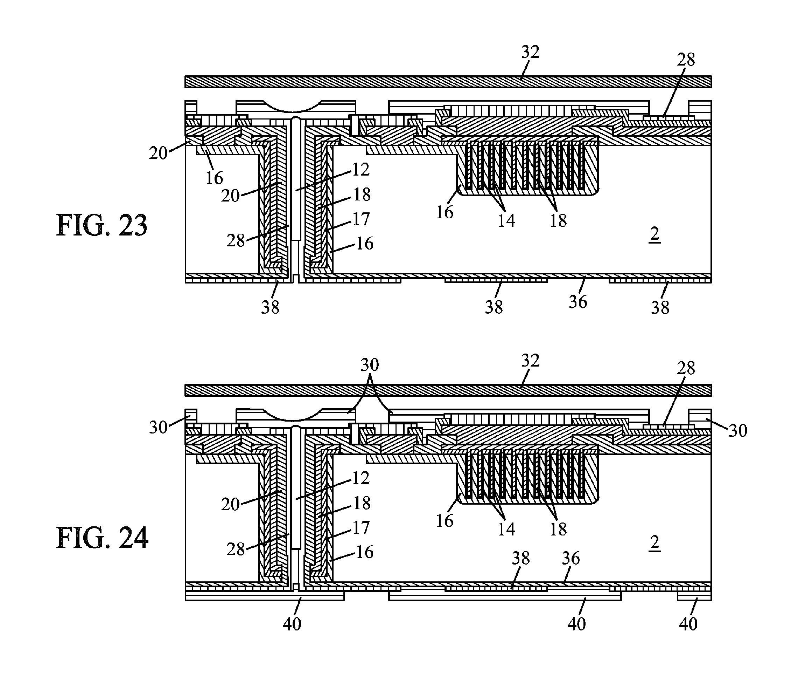

To make the access to the copper 28 easier from the lower side of the die, this lower side is metallised by deposition of a metallic layer 38, for example a layer of copper or of aluminium (figure 23). The deposition can be made by for example by PVD and then patterned by lithography and etching.

The metallic layer 38 is then passivated with an organic material, for example by lithography (figure 24). The metallic layer 38 is then partially recovered by an organic material layer 40 (a mineral material could also be used here). At the end of the process, the obtained die is removed from its glass substrate 32.

As it will clearly appear to the person having ordinary skill in the art, additional interconnection levels can be built up by repeating the same process sequence.

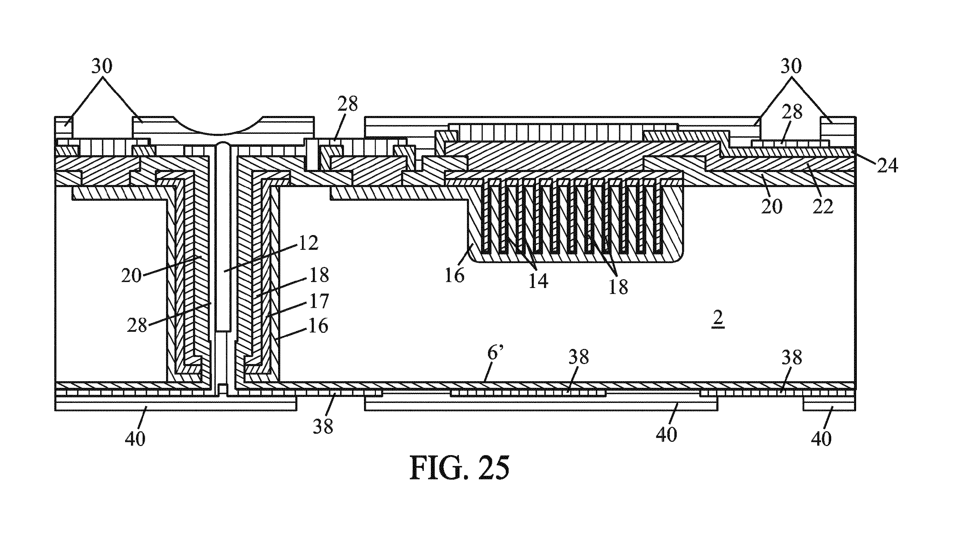

Figure 25 shows the die realised by the process described here before. This die comprises a through silicon via (TSV) which can be used to form a co-axial or a tri-axial TSV. Around the hole 12, there is a layer of copper 28 which is conductive. The copper is isolated from an other conductive layer, the phosphorous doped layer 16, by a via insulation comprising an oxide layer 20 and a dielectric layer 17. The oxide layer 20 prevents the diffusion of the copper 28.

The phosphorous doped layer 16 is a n-type doped layer. It is surrounded by a p-type doped substrate 2 and forms with this substrate a diode.

This new structure allows first a direct current insulation from the via with the surrounding substrate. The oxide layer 20 and the dielectric layer 17 allow such insulation. It also allows a reduction of the coupling between the TSV and the surrounding material for alternative currents (AC), for example RF (Radio Frequency) currents. The diode around the via can be polarised. So its capacity is variable and can be adapted to the frequency of the current traversing the TSV.

If the TSV is used for co-axial application, the substrate will preferably have a high resistivity, for example more than 1 kΩ.cm (i.e. 10 Ω.m). If the TSV is used for tri-axial application, the substrate will preferably have a low resistivity, for example 30 mΩ.cm (i.e. 3.10⁻⁴ Ω.m).

The TSV extends from the upper side of the die to its lower side. Its diameter is for example comprised between 40 µm and 150 µm (1 µm=10⁻⁶ m) and the aspect ratio of this hole (i.e. the ratio between its depth -or the thickness of the substrate after thinning- and its diameter) is for example comprised between 1 and 30. The hole outer contour can have any shape: circular, rounded, polygonal... the circular or rounded shape being the preferred shapes.

The doped layer, corresponding in the description of the phosphorous doped layer 16, in the finished die extends all around the hole, from the upper side of the silicon substrate to its lower side. It forms in this way a barrier between the hole and the substrate and is acting as a first shielding conductive layer in case of a co-axial or tri-axial application. In the description above, the substrate is a p-doped substrate and the doped layer is a n-doped layer. More generally, according to the invention, the doping specie of the doped layer is the opposite type of the bulk substrate.

For the doped layer around the hole and in contact with the substrate, the doping specie is preferably phosphorous (but arsenic could also be used for a n-doping or boron for a p-doping). The concentration of dopants in the doped layer is for example comprised between 10¹³ and **10¹⁹** atoms per cubic centimetre (between E13 a.cm⁻³ and E19 a.cm⁻³).

In this way, the TSV is surrounded by a conductive area obtained by diffusion of a opposite type dopant specie compared to the substrate. In this way, a PN junction is formed over all the height of the TSV between the TSV and the substrate. This junction is a tubular junction shielding the TSV and which can be polarised, the cathode being the conductive layer and the anode the substrate.

The described structure allows obtaining a co-axial configuration by connecting
- the inner conductive layer (copper 28) to a signal, and
- the first shielding layer (diffused), i.e. the phosphorous doped layer 16, to the ground.

In this configuration (co-axial), the bulk substrate can be left floating or can be also connected to the ground.

By connecting
- the inner conductive layer (copper 28) to a signal,
- the conductive layer (phosphorous doped layer 16) to the same voltage than the signal -by using for example a buffering amplifier having a gain of 1- and
- the substrate 2 to the ground,
one can also obtain a tri-axial configuration. Since the bulk substrate is connected to the ground, the tubular diode is blocked in reverse mode and isolates in this way electrically the first shielding layer (diffused) from the substrate.

The tri-axial TSV has advantageous electrical properties. It allows EMI (ElectoMagnetic Interference) shielding, parasitic capacitance reduction and impedance adaptation. Since the tubular diode can be polarised, the impedance of this diode can be adapted while for prior art tri-axial TSV the insulation is realised by an oxide layer which has a constant voltage capacity. By adapting the impedance, it is possible to limit the reflection of a signal at an end of the TSV and to improve the transmission of the signal.

This tri-axial structure for a TSV is advantageous in comparison with a prior art structure having two metallic layers because one isolating layer is missing. The tubular diode acts as a isolating layer.

The described tubular diode can also be used as a separate component from the TSV. In this case, a high integration density can be obtained.

This tubular diode also offers a superior junction surface ratio compared to footprint.

Although embodiments of the present disclosure have been described in detail, those skilled in the art should understand that they may make various changes, substitutions and alterations herein within the scope of the present disclosure as defined in the following claims without departing from the spirit and scope of the present disclosure.

## Claims

1. A semiconductor die comprising a via realised in a bulk material (2), the via having an inner metallic conductor (28) isolated from a surrounding conductive area (16) by a dielectric layer (17, 20),
**characterised in that** the bulk material (2) is chosen in a set of doped semiconductor materials containing n-type and p-type materials, **in that** the surrounding conductive area (16) is in contact with the bulk material (2), and **in that** the surrounding conductive area (16) is made from a material chosen in a set of doped semiconductor materials containing n-type and p-type materials, the surrounding conductive area material being from one type among the n-type and the p-type, and the bulk material being from the other type among said n-type and said p-type.

2. A semiconductor die according to claim 1, **characterised in that** the bulk material (2) is doped silicon.

3. A semiconductor die according to claim 1 or claim 2, **characterised in that** the surrounding conductive area (16) is doped with phosphorus.

4. A semiconductor die according to one of claims 1 to 3, **characterised in that** the inner metallic conductor (28) is in copper.

5. A semiconductor die according to any of claims 1 to 4, **characterised in that** the thickness of the metallic layer (28) is at least 0.5 µm.

6. A semiconductor die according to any of claims 1 to 5, **characterised in that** the dielectric layer (17, 20) is made in a material chosen in the set of materials comprising silicon oxide, silicon nitride, low permittivity Silicon Oxycarbide and low permittivity polymers.

7. A semiconductor die according to any of claims 1 to 6, **characterised in that** it comprises at least one trench (14) capacity.

8. A manufacturing process for manufacturing a semiconductor die according to any of claims 1 to 7, **characterised in that** it comprises the steps of:
- providing a doped silicon substrate (2),
- etching a hole (12) in the silicon substrate (2) from a first side of the substrate, the hole (12) having at least a circumferential lateral wall,
- doping the surface of the circumferential lateral wall and forming a doped layer (16) so that the doping specie of the doped layer is the opposite type of the doping specie of the substrate (2),
- coating the doped layer (16) with a dielectric layer (17),
- coating the inner wall of the hole (12) with a metallic layer (28).

9. A manufacturing process according to claim 8, **characterised in that** the etched hole (12) has a bottom and **in that** a further step includes a grinding operation in which the substrate (2) is grinded from a side (6) opposite to the first side (4) of the substrate (2) until the bottom so that the hole (12) in the substrate becomes a through silicon via.

10. A manufacturing process according to claim 8 or 9, **characterised in that** the silicon substrate (2) is a p-doped material.

11. A manufacturing process according to claim 10, **characterised in that** the surface of the circumferential lateral wall is doped with phosphorous and **in that** the doping comprises the steps of:
- deposition of a phosphorous glass on the inner circumferential lateral surface of the hole by a low pressure chemical vapour deposition process,
- etching of the glass by using diluted hydro-fluoridric acid, and
- thermal treatment in an oven so that the dopant is driven into the substrate and activated.

12. A manufacturing process according to any of claims 8 to 11, **characterised in that** the dielectric layer (17, 20) is made of a material chosen in the set of materials containing silicon oxide, silicon nitride, silicon oxycarbide and polymers.

13. A manufacturing process according to any of claims 7 to 12, **characterised in that** it comprises a step of providing a barrier layer (26) between the metallic layer (28) and the dielectric layer (17, 20) to avoid the diffusion of the metal into the dielectric layer.

14. A manufacturing process according to any of claims 7 to 13, **characterised in that** during the etching of the hole (12), in a same step, trenches (14) are etched.

15. A manufacturing process according to claim 14, **characterised in that** the hole (12) and the trenches (14) are realised by Reactive Ion Etching (RIE).
